# EUROPEAN PATENT SPECIFICATION

(11) **EP 2 441 089 B1**
(45) Date of publication and mention of the grant of the patent: **24.04.2013**
(21) Application number: 09779718.7
(22) Date of filing: 10.06.2009
(51) Int. Cl.: H01L 23/433, H01L 23/42, H05K 7/20

(54) **COOLING ARRANGEMENT AND METHOD FOR ASSEMBLING THE COOLING ARRANGEMENT**
KÜHLANORDNUNG UND VERFAHREN ZUR MONTAGE DER KÜHLANORDNUNG
AGENCEMENT DE REFROIDISSEMENT ET SON PROCÉDÉ D'ASSEMBLAGE

(43) Date of publication of application: 18.04.2012
(73) Proprietor: Robert Bosch GmbH, 70442 Stuttgart (DE)
(72) Inventor: VAN ASSELDONK, Hans, NL-5683 LE Best (NL)
(86) International application number: PCT/EP2009/057213
(87) International publication number: WO 2010/142333

(56) References cited:
- EP-A2- 0 875 933
- JP-A- 61 290 743
- US-B1- 6 285 078

## Description

### State of the art

The invention relates to a cooling arrangement. More specifically the invention relates to a cooling arrangement comprising a heat generating electronic device, a heat sink for dissipating the heat generated by the electronic device, a plate section being arranged between the electronic device and the heat sink and a thermal paste contacting the plate section with the heat sink in a first area and the plate section with the electronic device in a second area. Furthermore, the invention relates to a method for assembling the said cooling arrangement.

Processing panels comprise one or more electronic devices often realized as active processing units like microcontrollers, DSPs, CPUs or the like. Due to the increasing operating frequencies and additionally due to the miniaturizing trend of these electronic devices the issue of dissipating the heat generated by the electronic devices is of increasing importance. The reason for the importance is that in case the dissipating of the heat is not sufficiently provided, the reliability and the lifetime of the electronic device and thus of the processing panel decrease dramatically.

It is known to use heat sinks, which are often embodied as aluminum bodies with fins or fans being thermally connected or coupled with the electronic device in order to dissipate the heat generated by the electronic device by means of heat conduction through the aluminum body and then by heat convection.

The document GB 2279807 A1 is addressed to a heat sink assembly for a multichip module and appears to be equivalent to the German document DE 44 10 467 C2. This document seems to represent the closest state of the art. In the document(s) a heat sink assembly is proposed for cooling a plurality of chips arranged on a printed circuit board, whereby according to Fig. 3 of the document one of the chips is thermally coupled by a thermal paste with a thermally conductive plate which is again thermally coupled by a second layer of thermal paste with the heat sink made of metal for dissipating the heat generated by the chip. Thus the way of heat conduction starts at the chip by generating the heat, which is conducted by the first layer of thermal paste to the thermally conductive plate and furthermore transported by the second layer of thermal paste from the thermally conductive plate to the heat sink.

US 6,285,078 B1 discloses an apparatus and a method for protecting the various components of a microprocessor. The apparatus includes a thermal spreader cap that is disposed between the processor die and the thermal plate. EP 0 875 933 A2 discloses a thermal interface pad assembly. JP 61290743 discloses a cooling apparatus for a semiconductor device comprising a thermal conductive sheet with a number of through-holes which are filled with thermal conductive fluid.

### Summary of the invention

According to the invention a cooling arrangement with the features of claim 1 and a method for assembling the cooling arrangement with the features of claim 11 are proposed. Preferred or advantageous embodiments of the invention are disclosed by the dependent claims, the description and the figures as attached.

The invention relates to a cooling arrangement comprising at least one heat generating electronic device. The cooling arrangement may only comprise one single electronic device or may comprise a plurality of such electronic devices, which may especially be realized in different ways and/or adapted to provide different functions. The electronic device or devices, respectively, may preferably be realized as an active device, especially an integrated circuit device or a chip, and/or may be realized as a processing unit, microcontroller, DSP, FPGA and/or any other digital processing unit.

The cooling arrangement further comprises a heat sink for dissipating the heat generated by the electronic device whereby the dissipation is preferably realized and/or supported by heat convection.

Further a plate section is arranged between the electronic device and the heat sink. The plate section may be a part of a more complex component, which allows for example a mechanically securing of the electronic device and/or an enhanced heat flow between electronic device and heat sink and/or other functionalities as explained later. The plate section covers preferably the whole or complete electronic device.

A thermal paste is provided, which contacts on the one hand side the plate section with the heat sink in a first area and on the other hand side the plate section with the electronic device in a second area. Each area can be realized as a layer, especially as a layer with a closed region or as a plurality of segments, like a plurality of dot regions.

The thermal paste is optionally called thermal grease, heat paste, heat sink paste and/or heat transfer paste and is especially a fluid substance preferably with mechanical properties similar to grease. The thermal paste increases the thermal conductivity of a thermal interface by compensating the irregular surfaces of the components. Thermal pastes may use or comprise one or more different thermally conductive substances like ceramic-based, metal-based and/or carbon-based substances. Preferably a thermal paste is used having a thermal conductivity between 0.5 - 5 W/(m·K). In other embodiments the thermal conductivity may be higher like more than 50 W/(m·K) or even higher than 100 W/(m·K).

According to the invention it is proposed to provide at least one opening, especially hole in the plate section which is/are filled with the thermal paste for connecting the first and the second area. It is especially possible that the thermal paste in the at least one opening forms the second area. Thus, the first and the second area are fluidically and/or thermally connected by the at least one opening in the plate section, especially so that a direct thermal passage way is formed between the electronic device and the heat sink.

It is a finding of the invention that providing areas of thermal paste on the contact surfaces of the electronic device and the heat sink allows that the cooling arrangement can be assembled without applying too strong forces on the electronic device as the thermal contact between electronic device, plate section and heat sink is realized in a tension-reduced manner by the areas of thermal paste.

A further advantage results from the fact that providing the openings or holes in the plate sections enables a free distribution of the thermal paste between the two areas. As a consequence the assembling of the cooling arrangement is simplified, because the amounts of thermal grease deposited for the first and second layer can mutually balance by flowing through the openings. It is also possible that the thermal paste is only deposited in one area and flows in a self-acting manner to the other area.

Thus, it is preferably claimed, that the openings are adapted to allow the thermal paste to protrude and/or to flow from one area to the other area, especially during assembling of a cooling arrangement. Preferably, the openings have a maximum diameter between 1 mm and 7 mm, preferably between 2 mm and 5 mm. This dimension of the openings makes it possible to put the thermal paste just on one side of the plate section, i.e. on the position of the first area or on the position of the second area, and distribute the thermal paste between the two layers during the assembly. The overall area of the openings are for example larger than 50%, preferably larger than 60% and especially larger than 80% of the surface of the electronic device covered by the plate section.

In a preferred development of the invention the plate section is part of an electromagnetic-shielding cover of the electronic device. The cover is adapted to shield the electronic device from emitting and/or receiving high-frequency radiation, which could disturb the electronic device and/or other electronic devices. It is furthermore preferred, that the electromagnetic-shielding cover is adapted to shield frequencies corresponding to the frequency of the electronic device. The frequency of the electronic device may be its operating frequency, which is for example more than 10 MHz, especially more than 20 MHz.

It is especially preferred, that the electromagnetic-shielding cover further comprises side plate sections surrounding and/or encompassing the electronic device. In this embodiment the electronic device is shielded in a vertical direction and four horizontal directions. Preferably, the electromagnetic-shielding cover is made of metal. Returning to the issue of the maximum diameters of the openings it is preferred, that the maximum diameter is adapted to the frequency of the electronic device, so that the shielding function is not disturbed.

In yet a further preferred embodiment the heat sink comprises a passive section, for example an extruded aluminum body optionally with a plurality of fins. In a possible realization, the passive section is embodied as a housing for the cooling arrangement. Additionally, the heat sink may comprise an active section, for example a fan for actively dissipating the heat by heat convection.

In one possible development the cooling arrangement is embodied as a processing panel, whereby the electronic device is arranged on a printed circuit board and the heat sink and/or the electromagnetic-shielding cover is mechanically coupled to the printed circuit board. The contact of the electronic device with the printed circuit board or a respective adapter structure may be realized for example as a BGA (ball grid array). The contact of the electromagnetic-shielding cover with the printed circuit board may be realized by soldering.

In a special embodiment, reflecting the possible advantages of the invention, it is preferred, that the second area is arranged on the electronic device in a tension-free manner. Especially no or only a little compressive force is applied from the second area to the electronic device.

In a further development of the invention the cooling arrangement comprises a plurality, at least two, of the electronic devices, whereby the plate section is realized as a common plate section for the plurality of the electronic devices. Such an arrangement can be called as a multiple chip module ("MCM"). In this arrangement an individual second area is allocated to each electronic device, which shall be thermally coupled to the common plate section. The advantage of this development is that due to the fluidic form of the thermal paste differences in heights resulting from different heights of the electronic devices or misalignments during assembling the electronic devices can be easily compensated.

A further subject-matter of the invention relates to a method for assembling the cooling arrangement as described before with the features of claim 11. In the claimed method a portion of the thermal paste is arranged on one side of the plate section and thus defining one of the areas. For example, the portion of the thermal paste may be deposited on the side of the plate section facing the heat sink. The thermal paste may be attached to the plate section or to the corresponding side of the heat sink. According to the invention the other area is formed by protruding or by flowing the thermal paste through or in the at least one opening of the plate section.

The advantage of this subject-matter can be seen in that the thermal paste needs only to be deposited once and not - as known by the cited prior art - twice during the assembly process. A further possible advantage is that the thermal paste is distributed by means of mounting the heat sink, so that the distribution of the thermal paste is fulfilled as one of the last steps during assembling of the cooling arrangement. As a consequence the risk of accidental contamination of other regions by the distributed thermal paste is reduced.

Summarized the possible advantages of the invention are that the thermal paste fills all the air gaps, tolerances and the like, so that no external force is needed to achieve a good thermal conductivity between electronic device, plate section and heat sink. The thermal paste only has to be applied once due to the fact that the cover or the plate section has holes in it. Furthermore, the construction according to the inventions results in a lower bill of material (BOM).

Further advantages or features of the invention will be apparent by the following description of a preferred embodiment of the invention and the figures as attached. The figures show:
Fig. 1 a 3D view of a cooling arrangement as an embodiment of the invention;
Fig. 2 a schematic cross-sectional view of the cooling arrangement of Fig.1.

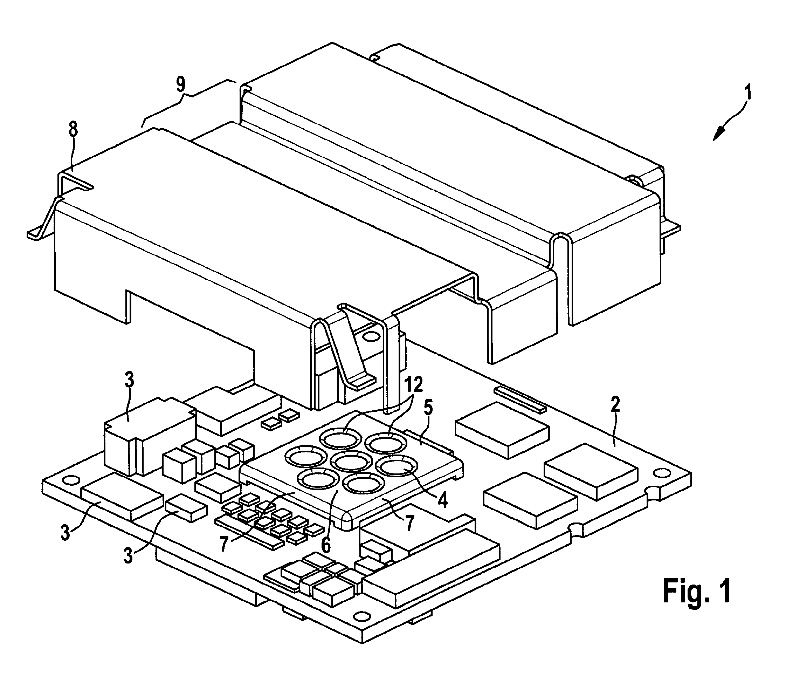

Fig. 1 shows a 3D schematic view of a cooling arrangement 1 realized as a processing panel, which - for example - can be used in digital cameras for digital image processing, as an embodiment of the invention.

The cooling arrangement 1 comprises a printed circuit board 2 on which a plurality of components 3 are arranged and electrically contacted by the board 2. In the middle of the board 2 a chip 4 as an electronic device is arranged and electrically contacted with the board 2 by a ball grid area (not shown). The chip 4 has a rectangular shape with the dimensions of for example 18 mm* 18 mm.

The chip 4 is covered by a metal or metalized shielding cover 5 which comprises a horizontal plate section 6 and four side plate sections 7, which are arranged perpendicular to the plate section 6. The cover 5 is for example made from a metal sheet by cutting and bending the sheet. The cover 5 has the function to shield electromagnetic waves generated by the chip 4 or at least attenuating these electromagnetic waves. The cover 5 is dimensioned larger than the chip 4, so that the cover 5 can encompass the chip 4. The cover is electrically contacted and mechanically fixed to the board 2 by soldering. For example the cover 5 has four legs (not shown) which are soldered to the board 2. The plate section 6 shows a plurality of holes 12 of a circular shape with a diameter of approximately 4 mm. According to the embodiment of Fig. 1 the plurality of holes 12 comprises a central hole and six further holes 12 which are arranged in a circle around the central hole, other distributions are possible. The form and diameter of the holes 12 are chosen so that the feature of the electromagnetic shielding of the chip 4 is not disturbed.

In order to ensure a cooling of the chip 4 a heat sink 8, realized as a 3D bended sheet metal part is provided, which shows a contact area 9 being adapted to have a touching or at least nearly touching contact with the cover 5 in the area of plate section 6. The heat sink 8 is furthermore designed as housing for the cooling arrangement 1.

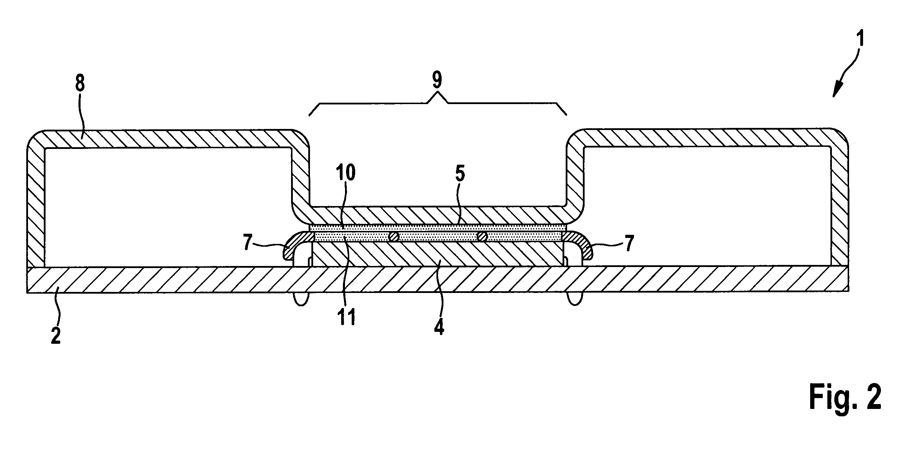

Fig. 2 shows a schematic cross-sectional view of the cooling arrangement 1 in an assembled state, whereby same numbers designate same components as in the Fig. 1.

In order to enhance the thermal contact between chip 4 and heat sink 8 a thermal paste is used. A first area 10 of the thermal paste embodied as a layer is disposed between the plate section 6 of the cover 5 and the heat sink 8 in the region of the middle area 9. The layer may have an average thickness of for example 0.5 mm. A second area 11 of the thermal paste is arranged in the holes 12 and contacts the chip 4. Thus the first and second area 10, 11 form a direct heat passage-way from the chip 4 to the heat sink 8. Heat generated by the chip 4 is transferred by the second area 11 of thermal paste to the first area 10 of the thermal paste and then to the heat sink 8. The plate section 6 works as a thermal shortcut between the two areas 10, 11 and/or as a distribution means for distributing the heat.

During assembly of the cooling arrangement 1 the thermal paste flows so that after a relaxation of the thermal paste the arrangement is tension-free or nearly tension-free in view of the chip 4. On the other hand side the two areas 10, 11 of thermal paste allow a reliable thermal contact between chip 4, plate section 6 and heat sink 8.

In a possible assembling method of the cooling arrangement 1 the chip 4, the cover 5 and the other components 3 are mounted to the board 2. Then a drip or portion of thermal paste is placed on the plate section 6. Next, the heat sink 8 is mounted, whereby the thermal paste is deformed to a flat disc and parts of the thermal paste are pressed or protruded through the holes 12. It is possible that some of the thermal paste is pressed between the plate section 6 and the chip 4. After the heat sink 8 reaches its final position, the disc forms the first area 10 and the protruded thermal paste the second area 11.

As an advantage of this assembling method it can be seen, that the thermal paste needs only to be inserted once into the cooling arrangement 1 and distributes itself freely on both sides of the cover 5, especially the plate section 6, thereby forming the first and the second area 10, 11.

## Claims

1. Cooling arrangement (1) comprising
a heat generating electronic device (4);
a heat sink (8) for dissipating the heat generated by the electronic device (4);
a plate section (6) being arranged between the electronic device (4) and the heat sink (8); and
a thermal paste contacting the plate section (6) with the heat sink (8) in a first area (10) and the plate section (6) with the electronic device (4) in a second area (11),
whereas one or more openings (12) in the plate section (6) being filled with the thermal paste and forming a connection between the first and the second area (10,11),
**characterized in that** that the openings (12) have a maximum diameter larger than 1 mm and smaller than 7 mm.

2. Cooling arrangement (1) according to claim 1, **characterized in that** the openings (12) are adapted to allow the thermal paste to protrude and/or to flow from one area to the other area (10,11) during assembling of the cooling arrangement (1).

3. Cooling arrangement (1) according to claim 1 or 2, **characterized in that** the openings (12) have a maximum diameter larger than 2 mm and/or smaller than 5 mm.

4. Cooling arrangement (1) according to one of the preceding claims, **characterized in that** the plate section (6) is part of an electromagnetic-shielding cover (5) of the electronic device (4).

5. Cooling arrangement (1) according to claim 4, **characterized in that** the electromagnetic-shielding cover (5) is adapted to shield frequencies corresponding to the frequency of the electronic device (4).

6. Cooling arrangement (1) according to claim 4 or 5, **characterized in that** the electromagnetic-shielding cover (5) comprises side plates (5) surrounding and/or encompassing the electronic device (4).

7. Cooling arrangement (1) according to one of the preceding claims, **characterized in that** the heat sink (8) comprises fins and/or a fan for dissipating the heat.

8. Cooling arrangement (1) according to one of the preceding claims, **characterized in that** the electronic device (4) is arranged on a printed circuit board (2) whereby the heat sink (8) and/or the electromagnetic-shielding cover (5) is mechanically coupled to the printed circuit board (2).

9. Cooling arrangement (1) according to one of the preceding claims **characterized in that** the second area (10) is arranged on the electronic device in a tension-free manner.

10. Cooling arrangement (1) according to one of the preceding claims **characterized by** comprising a plurality of the electronic devices (4), whereby the plate section (6) is realized as a common plate section for the plurality of the electronic devices (4).

11. Method for assembling the cooling arrangement (1) of one of the preceding claims, **characterized in that** a portion of the thermal paste is arranged on one side of the plate section (6) defining one of the areas, whereby the other area is formed by protruding the thermal paste through the openings (12) of the plate section (6).

## Patentansprüche

1. Kühleinrichtung (1) mit
einem Wärme erzeugenden elektronischen Gerät (4),
einem Wärmeableiter (8) zum Ableiten der Wärme, die von dem elektronischen Gerät (4) erzeugt wird,
einem Plattenabschnitt (6), der zwischen dem elektronischen Gerät (4) und dem Wärmeableiter (8) angeordnet ist, und
einer Thermopaste, die in einem ersten Bereich (10) den Plattenabschnitt (6) mit dem Wärmeableiter (8) und in einem zweiten Bereich (11) den Plattenabschnitt (6) mit dem elektronischen Gerät (4) kontaktiert,
wobei eine oder mehrere Öffnungen (12) in dem Plattenabschnitt (6) mit der Thermopaste gefüllt sind und eine Verbindung zwischen dem ersten und dem zweiten Bereich (10, 11) herstellen,
**dadurch gekennzeichnet, dass** die Öffnungen (12) einen Maximaldurchmesser aufweisen, der größer als 1 mm und kleiner als 7 mm ist.

2. Kühleinrichtung (1) nach Anspruch 1, **dadurch gekennzeichnet, dass** die Öffnungen (12) angepasst sind, dass ein Vordringen und/oder Fließen der Thermopaste von dem einen Bereich in den anderen Bereich (10, 11) während des Zusammenbauens der Kühleinrichtung (1) ermöglicht wird.

3. Kühleinrichtung (1) nach Anspruch 1 oder 2, **dadurch gekennzeichnet, dass** die Öffnungen (12) einen Maximaldurchmesser größer als 2 mm und/oder kleiner als 5 mm aufweisen.

4. Kühleinrichtung (1) nach einem der vorhergehenden Ansprüche, **dadurch gekennzeichnet, dass** der Plattenabschnitt (6) Teil einer elektromagnetischen Abschirmabdeckung (5) des elektronischen Gerätes (4) ist.

5. Kühleinrichtung (1) nach Anspruch 4, **dadurch gekennzeichnet, dass** die elektromagnetische Abschirmabdeckung (5) angepasst ist, Frequenzen abzuschirmen, die der Frequenz des elektronischen Gerätes (4) entsprechen.

6. Kühleinrichtung (1) nach Anspruch 4 oder 5, **dadurch gekennzeichnet, dass** die elektromagnetische Abschirmabdeckung (5) Seitenplatten (5) aufweist, die das elektronische Gerät (4) einschließen und/oder umfassen.

7. Kühleinrichtung (1) nach einem der vorhergehenden Ansprüche, **dadurch gekennzeichnet, dass** der Wärmeableiter (8) Rippen und/oder ein Gebläse für das Ableiten der Wärme aufweist.

8. Kühleinrichtung (1) nach einem der vorhergehenden Ansprüche, **dadurch gekennzeichnet, dass** das elektronische Gerät (4) auf einer Leiterplatte (2) eingerichtet ist, wobei der Wärmeableiter (8) und/oder die elektromagnetische Abschirmabdeckung (5) mechanisch an die Leiterplatte (2) gekoppelt sind.

9. Kühleinrichtung (1) nach einem der vorhergehenden Ansprüche, **dadurch gekennzeichnet, dass** der zweite Bereich (10) auf dem elektronischen Gerät in einer spannungsfreien Weise eingerichtet ist.

10. Kühleinrichtung (1) nach einem der vorhergehenden Ansprüche, **dadurch gekennzeichnet, dass** sie mehrere elektronische Geräte (4) aufweist, wobei der Plattenabschnitt (6) als ein gemeinsamer Plattenabschnitt für die mehreren elektronischen Geräte (4) realisiert ist.

11. Verfahren für das Zusammenbauen der Kühleinrichtung (1) nach einem der vorhergehenden Ansprüche, **dadurch gekennzeichnet, dass** ein Teil der Thermopaste auf der einen Seite des Plattenabschnitts (6) angeordnet ist, die einen der Bereiche festlegt, wodurch der andere Bereich durch das Vordringen der Thermopaste durch die Öffnungen (12) des Plattenabschnitts (6) gebildet wird.

## Revendications

1. Agencement (1) de refroidissement comportant :
un dispositif électronique (4) générateur de chaleur ;
un dissipateur thermique (8) servant à dissiper la chaleur générée par le dispositif électronique (4) ;
une section (6) de plaque agencée entre le dispositif électronique (4) et le dissipateur thermique (8) ; et
une pâte thermique mettant en contact la section (6) de plaque avec le dissipateur thermique (8) dans une première zone (10) et la section (6) de plaque avec le dispositif électronique (4) dans une deuxième zone (11),
une ou plusieurs ouvertures (12) in la section (6) de plaque étant remplies de la pâte thermique et formant une liaison entre la première et la deuxième zone (10, 11),
**caractérisé en ce que** les ouvertures (12) présentent un diamètre maximal supérieur à 1 mm et inférieur à 7 mm.

2. Agencement (1) de refroidissement selon la revendication 1, **caractérisé en ce que** les ouvertures (12) sont prévues pour permettre à la pâte thermique de dépasser et / ou s'écouler d'une zone à l'autre zone (10, 11) pendant l'assemblage de l'agencement (1) de refroidissement.

3. Agencement (1) de refroidissement selon la revendication 1 ou 2, **caractérisé en ce que** les ouvertures (12) présentent un diamètre maximal supérieur à 2 mm et / ou inférieur à 5 mm.

4. Agencement (1) de refroidissement selon l'une des revendications précédentes, **caractérisé en ce que** la section (6) de plaque fait partie d'un couvercle (5) de protection électromagnétique du dispositif électronique (4).

5. Agencement (1) de refroidissement selon la revendication 4, **caractérisé en ce que** le couvercle (5) de protection électromagnétique est prévu pour faire écran à des fréquences correspondant à la fréquence du dispositif électronique (4).

6. Agencement (1) de refroidissement selon la revendication 4 ou 5, **caractérisé en ce que** le couvercle (5) de protection électromagnétique comporte des plaques latérales (5) entourant et / ou enveloppant le dispositif électronique (4).

7. Agencement (1) de refroidissement selon l'une des revendications précédentes, **caractérisé en ce que** le dissipateur thermique (8) comporte des ailettes et / ou un ventilateur servant à dissiper la chaleur.

8. Agencement (1) de refroidissement selon l'une des revendications précédentes, **caractérisé en ce que** le dispositif électronique (4) est agencé sur une carte (2) à circuit imprimé, le dissipateur thermique (8) et / ou le couvercle (5) de protection électromagnétique étant couplés mécaniquement à la carte (2) à circuit imprimé.

9. Agencement (1) de refroidissement selon l'une des revendications précédentes **caractérisé en ce que** la deuxième zone (10) est agencée sans traction sur le dispositif électronique.

10. Agencement (1) de refroidissement selon l'une des revendications précédentes, **caractérisé en ce qu'**il comporte une pluralité des dispositifs électroniques (4), la section (6) de plaque étant réalisée sous la forme d'une section de plaque commune pour la pluralité des dispositifs électroniques (4).

11. Procédé d'assemblage de l'agencement (1) de refroidissement selon l'une des revendications précédentes, **caractérisé en ce qu'**une partie de la pâte thermique est agencée d'un côté de la section (6) de plaque définissant l'une des zones, l'autre zone étant formée en faisant dépasser la pâte thermique à travers les ouvertures (12) de la section (6) de plaque.
